# EUROPÄISCHE PATENTANMELDUNG

(11) **EP 4 815 647 A1**
(43) Veröffentlichungstag der Anmeldung: **30.09.2026**
(21) Anmeldenummer: 26166769.5
(22) Anmeldetag: 23.03.2026
(51) Int. Cl.: H05K 5/00, H04M 1/02, H04N 7/18, H05K 7/20

(54) **GEHÄUSE FÜR EIN HAUSKOMMUNIKATIONSENDGERÄT, HAUSKOMMUNIKATIONSENDGERÄT UND HAUSKOMMUNIKATIONSANLAGE**

(30) Priorität: 24.03.2025 DE 102025111225
(71) Anmelder: Horst Siedle GmbH & Co. KG., 78120 Furtwangen (DE)
(72) Erfinder: Kaiser, Jörg, 79312 Emmendingen (DE); Bärmann, Uli, 78120 Furtwangen (DE)
(74) Vertreter: Isarpatent

(57) **Zusammenfassung**

Die vorliegende Erfindung betrifft ein Gehäuse für ein Hauskommunikationsendgerät einer Hauskommunikationsanlage, insbesondere für eine Türstation, mit einem ersten Gehäuseelement, das zur Montage an einer Gebäudewand oder Tür ausgebildet ist, mit einem zweiten Gehäuseelement, das zur Montage an dem ersten Gehäuseelement ausgebildet ist, und mit einem zwischen dem ersten Gehäuseelement und dem zweiten Gehäuseelement angeordneten Trennelement, das dazu ausgebildet ist, mit dem zweiten Gehäuseelement einen Gehäuseinnenraum zu definieren, wobei das Trennelement dazu ausgebildet ist, Wärme von zumindest einer elektronischen Komponente, die in dem Gehäuseinnenraum angeordnet ist, zu dem ersten Gehäuseelement zu leiten. Die vorliegende Erfindung betrifft ferner ein Hauskommunikationsendgerät und eine Hauskommunikationsanlage.

## Beschreibung

### GEBIET DER ERFINDUNG

Die vorliegende Erfindung betrifft ein Gehäuse für ein Hauskommunikationsendgerät. Die vorliegende Erfindung betrifft ferner ein Hauskommunikationsendgerät eine Hauskommunikationsanlage.

### TECHNISCHER HINTERGRUND

Die vorliegende Erfindung bezieht sich auf das Gebiet der Hauskommunikation als Teil der Hausautomatisierung. Die Hausautomatisierung befindet sich im das Umfeld des intelligenten Wohnens, welches Lösungen im privaten oder geschäftlichen Wohn- und Arbeitsbereich bezeichnet, die auf die speziellen Bedürfnisse der Bewohner von privaten Wohnhäusern, Wohnblocks oder Geschäftshäuser ausgerichtet sind, bei denen Geräte, Systeme und Technologien eingesetzt werden, die mehr Effizienz, Komfort, Wirtschaftlichkeit, Flexibilität und Sicherheit schaffen.

Ein Aspekt der Hausautomatisierung bezieht sich auf die Hauskommunikation mittels entsprechender Hauskommunikationsendgeräte oder (Gegen-)Sprechanlagen. Moderne Hauskommunikationsanlagen umfassen typischerweise eine Vielzahl von verschiedenen Hauskommunikationsendgeräten, die miteinander über ein Verbindungsnetzwerk, wie z.B. ein KNX-Bussystem, gekoppelt sind. Man unterscheidet dabei zwischen so genannten Innenstationen, die in einem geschützten Bereich innerhalb des Hauses oder einer entsprechenden Wohnungseinheit angeordnet sind, und so genannte Türstationen oder Außenstationen, die im öffentlichen Bereich vor oder unmittelbar an der Haus- oder Gebäudetür angebracht sind und über welche Besucher mit Hausbewohnern in kommunikative Verbindung treten können. Diese Hauskommunikationsendgeräte weisen meist eine Klingel oder ein Klingeltastenfeld, einen Türöffner, eine Gegensprechanlage, eine Kamera und ein Display auf, über welche eine bidirektionale Kommunikation zwischen Besucher und Haus- oder Wohnungsbesitzer ermöglicht wird. Derartige Hauskommunikationsanlagen sind allgemein bekannt, so dass darauf nicht näher eingegangen werden muss.

Die vorliegende Erfindung sowie die ihr zugrundeliegende Problematik wird nachfolgend anhand eines als Türstation ausgebildeten Hauskommunikationsendgeräts einer Hauskommunikationsanlage erläutert, ohne die Erfindung darauf zu beschränken. Vielmehr kann die Erfindung auch für eine Innenstation vorteilhaft eingesetzt werden.

Türstationen von Hauskommunikationsanlagen sind aufgrund der Ausrichtung von Gebäudeeingängen oftmals so positioniert, dass sie zumindest für einen Teil des Tages direkter Sonneneinstrahlung ausgesetzt sind. Vor allem in Sommermonaten können sich die Türstationen aufgrund der vergleichsweisen höheren Außentemperaturen und längeren Helligkeitsphasen sowie einer höheren Sonneneinstrahlintensität sehr stark aufheizen, zum Teil auf Temperaturen weit über 100°C. Hinzu kommt, dass heutige Türstationen technisch immer komplexer aufgebaut sind und deren Mikroprozessor als Teil der Steuerung eine immer größere Rechenleistung aufweist, die aufgrund der Verlustleistung die Temperatur im Inneren der Türstation zusätzlich erhöht.

Gleichzeitig wird an Türstationen aber die Anforderung gestellt, selbst bei extremen äußeren Bedingungen, wie sie eben geschildert wurden, noch voll funktionsfähig zu bleiben. Gleichzeitig wird von elektronischen Geräten eine immer höhere Leistungsfähigkeit verlangt.

Es ist allgemein bekannt, dass extreme Belastungen sich auf die Lebensdauer von elektrischen und vor allem elektronischen Geräten auswirken können. Bei dauerhaften hohen Temperaturen können elektrische, elektronische und mechanische Komponenten degradieren, was bis hin zum Funktionsausfall führen kann.

Des Weiteren besteht bei Außenstationen die Gefahr, dass diese durch Umwelteinflüsse und Vandalismus beschädigt werden, wenn die Außenhaut bzw. das Gehäuse keine ausreichend mechanische Stabilität gegenüber Umwelteinflüssen und Vandalismus aufweisen.

Dies ist ein Zustand, den es zu verbessern gilt.

### ZUSAMMENFASSUNG DER ERFINDUNG

Vor diesem Hintergrund besteht die Aufgabe der vorliegenden Erfindung darin, ein im Hinblick auf thermische und mechanische Belastung verbessertes Gehäuse für ein Hauskommunikationsendgerät anzugeben.

Erfindungsgemäß wird diese Aufgabe durch ein Gehäuse mit den Merkmalen des Patentanspruchs 1, durch ein Hauskommunikationsendgerät mit den Merkmalen des Patentanspruchs 14 und/oder eine Hauskommunikationsanlage mit den Merkmalen des Patentanspruches 15 gelöst.

Demgemäß ist vorgesehen:
- Ein Gehäuse für ein Hauskommunikationsendgerät einer Hauskommunikationsanlage, insbesondere für eine Türstation, mit einem ersten Gehäuseelement, das zur Montage an einer Gebäudewand oder Tür ausgebildet ist, mit einem zweiten Gehäuseelement, das zur Montage an dem ersten Gehäuseelement ausgebildet ist, und mit einem zwischen dem ersten Gehäuseelement und dem zweiten Gehäuseelement angeordneten Trennelement, das dazu ausgebildet ist, mit dem zweiten Gehäuseelement einen Gehäuseinnenraum zu definieren, wobei das Trennelement dazu ausgebildet ist, Wärme von zumindest einer elektronischen Komponente, die in dem Gehäuseinnenraum angeordnet ist, zu dem ersten Gehäuseelement zu leiten.
- Ein Hauskommunikationsendgerät, das eine Innenstation und/oder Türstation einer Hauskommunikationsanlage ausbildet, aufweisend ein erfindungsgemäßes Gehäuse.
- Eine Hauskommunikationsanlage, mit mindestens einer Innenstation und mit mindestens einer Türstation, wobei zumindest eine Innenstation und/oder Türstation als Hauskommunikationsendgerät mit einem erfindungsgemäßen Gehäuse ausgebildet ist.

Die der vorliegenden Erfindung zugrunde liegende Erkenntnis besteht darin, dass extreme thermische Umgebungsbedingungen in Kombination mit einer hohen internen Betriebstemperatur sich negativ auf die Lebensdauer von Hauskommunikationsendgeräten auswirken können.

Die der vorliegenden Erfindung zugrunde liegende Idee besteht nun darin, die Temperatur innerhalb eines Hauskommunikationsendgeräts zu reduzieren. Dazu schlägt die vorliegende Erfindung ein Gehäuse vor, welches in der Lage ist, die im Innern auftretenden Temperaturen zunächst in das Gehäuse und über das Gehäuse selbst nach außerhalb des Hauskommunikationsendgeräts zu leiten. Dadurch werden sowohl die äußeren als auch die internen thermischen Einflüsse effektiv ausgeglichen. Ferner wird so die Lebensdauer von Hauskommunikationsendgeräten verlängert und einem Ausfall dieser entgegengewirkt.

Erfindungsgemäß ist es daher vorgesehen, dass im Innern des Gehäuses ein Trennelement angeordnet ist, das beispielsweise über Kontakt mit der elektronischen Komponente thermisch gekoppelt sein kann. Über die thermische Kopplung kann die thermische Energie daher über das Trennelement zu dem ersten Gehäuseelement geleitet werden. Insbesondere kann eine weitere thermische Kopplung zwischen dem ersten Gehäuseelement und dem zweiten Gehäuseelement vorliegen, sodass die thermische Energie weiterhin auch an das zweite Gehäuseelement weitergeleitet werden kann.

Vorteilhafterweise bilden die beiden Gehäuseelemente jeweils einen Teil der Außenhaut des Hauskommunikationsendgeräts aus, sodass die thermische Energie von dem Gehäuse an die Umgebung abgegeben werden kann. Dadurch kann erreicht werden, dass eine im Innern des Gehäuses ansteigende Temperatur an die Umgebung abgegeben werden kann. Erfindungsgemäß kann daher die Temperatur innerhalb des Gehäuses reduziert werden, wodurch die Lebensdauer der elektronischen Komponenten erhöht werden kann.

Als Gehäuseinnenraum ist insbesondere ein dreidimensionaler Raum zu verstehen, in welchem zumindest die zumindest eine elektronische Komponente angeordnet ist. In dem Gehäuseinnenraum können weitere Elemente angeordnet werden, welche insbesondere funktional zu einer Mikrofoneinheit, einer Lautsprechereinheit, einem Tastenfeld und dergleichen beitragen. Beispielsweise kann das Gehäuse, insbesondere das zweite Gehäuseelement, mehrteilig ausgebildet sein, wobei ein Teil der Außenhaut zumindest ein Tastenfeld umfassen kann.

Der Gehäuseinnenraum ist insbesondere als nach außen abgeschlossener Raum zu verstehen, der zwischen dem zweiten Gehäuseelement und dem Trennelement ausgebildet ist. Zumindest eine verschließbare Öffnung kann insbesondere in dem Trennelement vorgesehen sein, um bei der Montage zumindest eine elektronische Komponente zu erreichen bzw. kontaktieren.

Vorteilhafte Ausgestaltungen und Weiterbildungen ergeben sich aus den weiteren Unteransprüchen sowie aus der Beschreibung unter Bezugnahme auf die Figuren der Zeichnung.

In einer vorteilhaften Ausführungsform kann das Trennelement zumindest einen Teilbereich aufweisen, der eine geringere Querschnittsfläche als zumindest ein weiterer Bereich des Trennelements aufweist. Mit anderen Worten kann die geringere bzw. verringerte Querschnittsfläche eine Materialdünung ausbilden. Der Bereich mit geringerer Querschnittsfläche bzw. die Materialdünnung dient dazu, Wärme von einer Seite des Trennelements auf die andere Seite des Trennelements ohne größeren Widerstand hindurch zu leiten. Damit kann insbesondere gewährleistet werden, dass Wärmeenergie, welche von der zumindest einen elektronischen Komponente ausgeht, durch das Trennelement hindurch geleitet werden kann, d. h. von einer Seite des Trennelements auf die andere Seite des Trennelements geleitet werden kann, ohne das Trennelement an sich auf zu heizen. Ein Aufheizen des Trennelements gilt es zu verhindert, da dieses im Inneren des Gehäuses angeordnet ist und zur weiteren Temperaturerhöhung innerhalb des Gehäuses führen würde.

In einer weiteren Ausführungsform kann der Teilbereich eine geringere Querschnittsfläche als daran angrenzende Bereiche des Trennelements aufweisen und/oder eine einseitige Vertiefung in dem Trennelement ausbilden. Vorteilhafterweise weist lediglich der Teilbereich eine Materialdünnung auf, sodass das Trennelement an sich weiterhin mit genügender Stabilität ausgebildet sein kann. So kann das Trennelement an sich derart ausgebildet sein, dass es den mechanischen Eigenschaften standhält, wie insbesondere der Ausbildung einer Trennwand zur Definition des Gehäuseinnenraums und/oder zur Bereitstellung einer Montagewand, an welcher die zumindest eine elektronische Komponente fixiert werden kann.

Das erste Gehäuseelement kann einen zu der Vertiefung des Trennelements korrespondierende Teilbereich aufweisen. Demnach kann das erste Gehäuseelement in dem korrespondierenden Teilbereich mit einem größeren Querschnitt ausgebildet sein als in daran angrenzenden Bereichen. Über diese Materialdickung kann die Wärmeaufnahme erhöht werden. Weiterhin kann ein erstes Gehäuseelement mit konstantem Querschnitt derart geformt sein, dass es in eine Vertiefung hineinragt.

In einer vorteilhaften Ausführungsform kann der Teilbereich an eine Größe und/oder Form der zumindest einen elektronischen Komponente angepasst sein. Beispielsweise kann der Teilbereich eine rechteckige, quadratische, teilkreisförmige, elliptische oder Ähnliche Form aufweisen. So kann der Teilbereich beispielsweise als einseitige Vertiefung ausgebildet sein, die einen rechteckigen oder quadratischen Querschnitt aufweist. Die Größe der rechteckigen beziehungsweise quadratischen Vertiefung kann an die Größe der elektronischen Komponente angepasst sein. Dabei kann die elektronische Komponente in die Vertiefung eingesetzt werden. Es ist weiterhin denkbar, dass die elektronische Komponente an der gegenüberliegenden Seite der Vertiefung mit dem Trennelement kontaktiert wird. In beiden Fällen ist eine Weiterleitung der thermischen Energie durch das Trennelement hindurch ohne größeren Wärmewiderstand möglich.

In einer weiteren Ausführungsform kann das Trennelement zumindest ein Kunststoffmaterial umfassen oder aus einem Kunststoffmaterial ausgebildet sein. Ein Kunststoffmaterial ist insbesondere daher vorteilhaft, da dieses die Wärmeenergie nicht speichert, sondern weiterleitet. So kann beispielsweise eine Silikonmaterial oder ein Silikon verwendet werden. Es ist weiterhin denkbar, einen 2-Komponenten-Werkstoff einzusetzen, wobei beispielsweise der Teilbereich ein anderes Material als der übrige Bereich des Trennelements aufweist.

In einer weiteren Ausführungsform kann das erste Gehäuseelement und/oder das zweite Gehäuseelement aus einem Gussmaterial ausgebildet sein. Beispielsweise können das erste und/oder zweite Gehäuseelement aus einem Druckgussmaterial ausgebildet sein, wobei die mechanische Stabilität, insbesondere auch im Hinblick auf Vandalismus, Temperatureinflüssen und Wettereinflüssen verbessert werden kann. Ein Druckgussmaterial es insbesondere daher vorteilhaft, da dieses eine mechanische Schutzfunktion und zugleich eine Kühlfunktion ausbilden kann.

So kann das Gehäuse als eine Art Kühlkörper zum Abführen von im Inneren des Gehäuses entstehender Wärme dienen.

In einer weiteren Ausführungsform kann die elektronische Komponente zumindest einen Mikrocontroller oder Mikroprozessor aufweisen, der bevorzugt direkt oder mittels einer wärmeleitenden Schicht mit dem Trennelement kontaktierbar ist. So kann die elektronische Komponente an dem Trennelement direkt kontaktiert und befestigt sein. Weiterhin kann eine wärmeleitende Schicht zwischen der elektronischen Komponente und dem Trennelement angeordnet sein. Durch die wärmeleitende Schicht kann die Wärmeleitung von der elektronischen Komponente zu dem Trennelement optimiert werden.

In einer weiteren Ausführungsform kann das Trennelement zur Abdichtung des Gehäuseinnenraums ein umlaufendes Dichtelement aufweisen. Das umlaufende Dichtelement kann als umlaufende Dichtung ausgebildet sein, die insbesondere das Trennelement gegenüber dem zweiten Gehäuseelement abdichtet. So kann das Dichtelement beispielsweise an einer Außenkarte des Trennelements verlaufen. Dabei kann die Außenkante des Trennelements gegenüber dem zweiten Gehäuseelement abgedichtet werden. Das Gehäuse kann daher als ein stabiles und nach außen hin abgedichtetes Gehäuse ausgebildet sein.

In einer weiteren Ausführungsform kann das erste Gehäuseelement eine Haltevorrichtung aufweisen, an welcher das zweite Gehäuseelement während der Montage in einer Montageposition an dem ersten Gehäuseelement ausrichtbar und haltbar ist, wobei bevorzugt das Trennelement in der Montageposition erreichbar ist. Die Haltevorrichtung kann zumindest einen Vorsprung und/oder ein Hakenelement aufweisen. Das zweite Gehäuseelement kann eine zu der Haltevorrichtung korrespondierende Einhängevorrichtung aufweisen, die zumindest eine zu dem zumindest einen Vorsprung und/oder Hakenelement korrespondierende Ausnehmung und/oder Aufnahme aufweist. Beispielsweise kann so das erste Gehäuseelement zunächst an einer Gebäudewand montiert werden. Dies ist insbesondere vorteilhaft, da an dem ersten Gehäuseelement keine teuren Komponenten angeordnet sind. Demnach kann das erste Gehäuseelement bereits vormontiert werden, ohne dass die elektronischen Komponenten Witterungsbedingungen oder Vandalismus ausgesetzt werden. Das zweite Gehäuseelement kann dann an der Haltevorrichtung des ersten Gehäuseelements eingehängt werden, um beispielsweise die inneren Anschlüsse und Verkabelung zu montieren. Das zweite Gehäuseelement kann sich an dem ersten Gehäuseelement abstützen, sodass dieses von einer Montageperson nicht gehalten werden muss.

In einer weiteren Ausführungsform kann das erste Gehäuseelement eine Rastvorrichtung aufweisen, an welcher das zweite Gehäuseelement zur Montage in einer Endposition an dem ersten Gehäuseelement rastbar ist, wobei das zweite Gehäuseelement in der Endposition an der Haltevorrichtung und an der Rastvorrichtung ausrichtbar und/oder arretierbar ist. Die Rastvorrichtung und die Haltevorrichtung können an gegenüberliegenden Seiten an dem ersten Gehäuseelement vorgesehen sein. Dadurch können die beiden Gehäuseelemente an zwei am weitesten voneinander beanstandeten Positionen miteinander verbunden werden. Das zweite Gehäuseelement kann eine zu der Rastvorrichtung korrespondierende Aufnahme bzw. Rastvorrichtung aufweisen. In einer Endposition kann daher das zweite Gehäuseelement an dem ersten Gehäuseelement arretiert sein, wodurch die Endmontageposition für das Hauskommunikationsendgerät bereitgestellt wird. Für eine zusätzliche Arretierung kann ein Befestigungsmittel vorgesehen sein, beispielsweise eine Inbusschraube oder dergleichen, insbesondere mit innenliegendem Pin. Das Befestigungsmittel kann bevorzugt derart am Gehäuse, insbesondere am zweiten Gehäuseelement, angeordnet werden, dass dieses von außen nicht sichtbar ist und demnach vor unsachgemäßer Entfernung geschützt ist. Insbesondere kann das Befestigungsmittel versenkt im zweiten Gehäuseelement angeordnet sein.

In einer weiteren Ausführungsform kann das erste Gehäuseelement zumindest eine Befestigungsschnittstelle aufweisen, über welche das Gehäuse an der Gebäudewand oder Tür befestigbar ist. Die Befestigungsschnittstelle kann zur Aufnahme von Schraubenmitteln ausgelegt sein. Beispielsweise können zumindest zwei unterschiedlich zueinander ausgerichtete Langlöcher vorgesehen sein, sodass eine Ausrichtung in vertikaler und horizontaler Richtung möglich ist. Dabei spielt es keine Rolle, ob die Befestigung in der Aufputz- oder Unterputz-Variante erfolgt.

In einer weiteren Ausführungsform kann das zweite Gehäuseelement eine Lautsprechereinheit und eine Mikrofoneinheit aufweisen, die beabstandet zueinander an dem zweiten Gehäuseelement angeordnet sind, wobei diese gegenüber dem zweiten Gehäuseelement abgedichtet sind. So kann die Mikrofoneinheit beispielsweise an einer Gehäuseunterseite bzw. im unteren Bereich des Gehäuses vorgesehen sein. Die Lautsprechereinheit kann davon beabstandet im oberen Bereich des Gehäuses vorgesehen sein. Dadurch kann insbesondere eine Rückkopplung der Mikrofoneinheit mit der Lautsprechereinheit verhindert werden. Des Weiteren ist die Mikrofoneinheit bevorzugt derart angeordnet, dass diese vor Feuchtigkeit geschützt ist, und nicht mit einer Oberseite des Gehäuses, insbesondere des zweiten Gehäuseelements, in Kontakt ist.

Die Lautsprechereinheit kann beispielsweise zumindest einen Öffnungsschlitz und zumindest ein Lautsprecherelement umfassen. Es ist weiterhin denkbar, dass der zumindest eine Öffnungsschlitz durch ein Gitterelement, insbesondere ein Kunststoffgitter als Feuchtigkeitssperre, überspannt wird. Dadurch kann verhindert werden, dass Regenwasser direkt an eine Membran eines Lautsprecherelements gelangt.

In einer weiteren Ausführungsform kann die Lautsprechereinheit zumindest ein Lautsprecherelement und unterhalb des Lautsprecherelements zumindest ein Feuchteaustrittsloch aufweisen, wobei Feuchtigkeit von dem Lautsprecherelement zu dem Feuchteaustrittsloch führbar und durch das Feuchteaustrittsloch aus dem zweiten Gehäuseelement nach außerhalb des Gehäuses leitbar ist. Dabei kann eine Bewegung der Membran des zumindest einen Lautsprecherelements ein Herauslaufen des eingetretenen Regenwassers in Richtung des Feuchteaustrittslochs unterstützen.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnungen angegebenen Ausführungsbeispiele näher erläutert. Es zeigen dabei:
- Fig. 1: Detailansichten eines Gehäuses in einer möglichen Ausführungsform;
- Fig. 2: eine weitere Detailansicht eines Gehäuses in einer möglichen Ausführungsform;
- Fig. 3: ein erstes und zweites Gehäuseelement in einer möglichen Ausführungsform;
- Fig. 4: eine mögliche Ausführungsform eines Hauskommunikationsendgeräts;
- Fig. 5: eine Detailansicht aus Fig. 4;
- Fig. 6: eine weitere Detailansicht aus Fig. 4;
- Fig. 7: eine weitere mögliche Ausführungsform eines Hauskommunikationsendgeräts;
- Fig. 8: eine Detailansicht aus Fig. 7;
- Fig. 9: eine schematische Darstellung eines Hauskommunikationsendgeräts während und nach der Montage;
- Fig. 10: ein Gehäuse in einer weiteren möglichen Ausführungsform;
- Fig. 11: eine Montageposition der Ausführungsform aus Fig. 10;
- Fig. 12: ein Gehäuse in weiteren möglichen Ausführungsformen;
- Fig. 13: ein zweites Gehäuseelement in einer möglichen Ausführungsform;
- Fig. 14: eine weitere Ansicht der Ausführungsform aus Fig. 13;
- Fig. 15: eine weitere Ansicht der Ausführungsform aus Fig. 13;
- Fig. 16: eine weitere Ansicht der Ausführungsform aus Fig. 13;
- Fig. 17: eine Detailansicht aus Fig. 16;
- Fig. 18: ein erstes Gehäuseelement in einer weiteren möglichen Ausführungsform;
- Fig. 19: weitere Ansichten der Ausführungsform aus Fig. 18;
- Fig. 20: eine Schnittdarstellung aus Fig. 19.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausführt ist - jeweils mit denselben Bezugszeichen versehen.

### BESCHREIBUNG VON AUSFÜHRUNGSBEISPIELEN

Die folgenden Figuren zeigen beispielhafte Ausführungsformen eines erfindungsgemäßen Gehäuses 10 und eines erfindungsgemäßen Hauskommunikationsendgeräts 20, wie diese beispielsweise bei einer erfindungsgemäßen Kommunikationsanlage verwendet werden können.

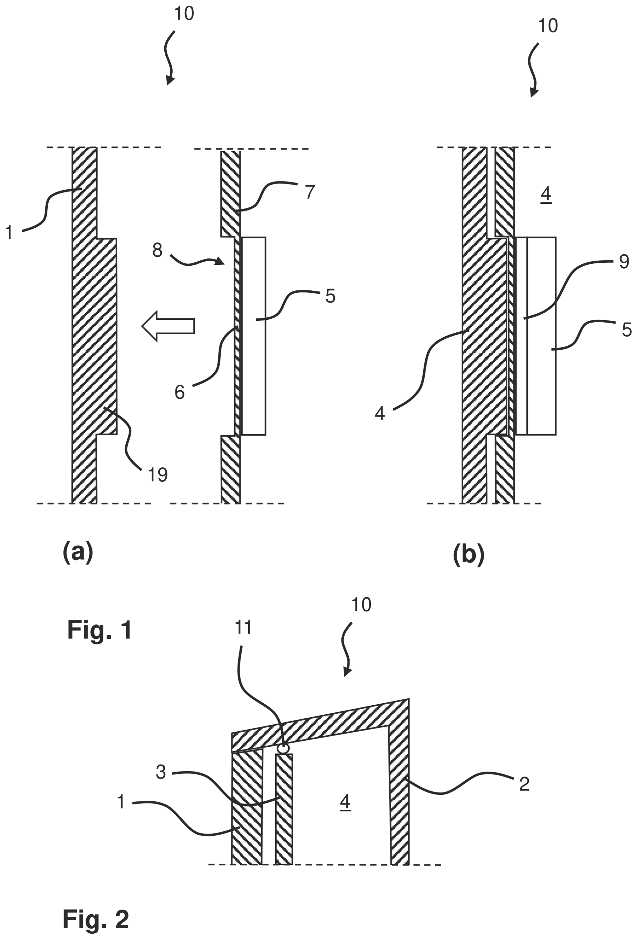

Fig. 1 zeigt einen Ausschnitt eines Gehäuses 10 in einer möglichen Ausführungsform. Der Ausschnitt zeigt den Teil eines ersten Gehäuseelements 1 sowie eines Trennelement 3. Das Trennelement 3 ist ausgebildet, Wärme von einer elektronischen Komponente 5 zu dem ersten Gehäuseelement 1 zu leiten. Dazu weist in dieser Ausführungsform das Trennelement 3 einen Teilbereich 6 auf, der eine geringeren Querschnittsfläche als ein weiterer Bereich 7 des Trennelements 3 aufweist.

Fig. 1(a) zeigt eine Situation vor Kontaktierung des ersten Gehäuseelements 1 mit dem Trennelement 3. Das Trennelement 3 weist in der dargestellten Ausführungsform eine einseitige Vertiefung 8 auf, durch welche der Teilbereich 6 ausgebildet wird. Die elektronische Komponente 5, beispielsweise ein Mikrocontroller oder Mikroprozessor, kann mit dem Trennelement 3 derart kontaktiert werden, dass die Vertiefung 8 frei bleibt. Demnach kann das erste Gehäuseelement 1 einen zu der Vertiefung 8 korrespondierenden Teilbereich 19 aufweisen, der wie in Fig. 1(b) dargestellt in die Vertiefung 8 eingesetzt werden kann. Dies stellt eine beispielhafte Kontaktierung zwischen dem ersten Gehäuseelement 1 und dem Trennelement 3 dar, wobei eine Wärmeübertragung von der elektronischen Komponente 5 durch das Trennelement 3 zu dem ersten Gehäuseelement 1 erfolgen kann.

Die elektronische Komponente 5 kann direkt mit dem Trennelement 3 kontaktiert werden, wie in Fig. 1(a) dargestellt, oder über zumindest eine wärmeleitende Schicht 9, wie in Fig. 1(b) dargestellt. Wie dargestellt kann die elektronische Komponente 5 in der Größe an den Teilbereich 6 angepasst sein.

Fig. 2 zeigt einen Randbereich eines Gehäuses 10, wobei das zweite Gehäuseelement 2 dargestellt ist. Zwischen dem zweiten Gehäuseelement 2 und dem Trennelement 3 wird demnach ein Gehäuseinnenraum 4 ausgebildet. Der Gehäuseinnenraum 4 kann abgedichtet ausgebildet sein, wobei ein Dichtelement 11 zwischen dem Trennelement 3 und dem zweiten Gehäuseelement 2 vorgesehen sein kann.

Das Dichtelement 11 ist bevorzugt als umlaufendes Dichtelement ausgeführt, wobei beispielsweise ein Randbereich des Trennelements 3 gegenüber einer Innenseite des zweiten Gehäuseelements 2 abgedichtet werden kann. In dem Gehäuseinnenraum 4 ist die zumindest eine elektronische Komponente 5 angeordnet.

Wie in Fig. 2 dargestellt können sich das erste Gehäuseelement 1 und das zweite Gehäuseelement 2 kontaktieren, sodass die Wärme von dem ersten Gehäuseelement 1 auf das zweite Gehäuseelement 2 übertragen werden kann. Dadurch kann die Kühlfunktion verbessert werden.

Das erste Gehäuseelement 1 sowie das zweite Gehäuseelement 2 sind insbesondere aus einem Stahlmaterial oder aus Metall ausgebildet. So kann beispielsweise ein Druckgussmaterial, wie insbesondere Zinkdruckguss, verwendet werden, wodurch eine verbesserte mechanische Stabilität erreicht werden kann. Ein Stahlmaterial bzw. Gussmaterial kann weiterhin als Kühlkörper dienen, und ein Abführen von im Innern des Gehäuses 10 entstehender Wärme fördern.

Das Trennelement 3 ist insbesondere aus einem Kunststoffmaterial oder aus Kunststoff ausgebildet, wie beispielsweise einem Silikonmaterial, einem Silikon oder auch einem 2-Komponenten-Werkstoff. In einer Ausführungsform kann das Trennelement 3 aus einem einzigen Werkstoff geformt sein. In einer alternativen Ausführungsform kann insbesondere der Teilbereich 6 ein anderes Material Kunststoffmaterial aufweisen als die umliegenden Bereiche 7. Die Materialien können dabei an die Funktion der Wärmeleitung angepasst sein.

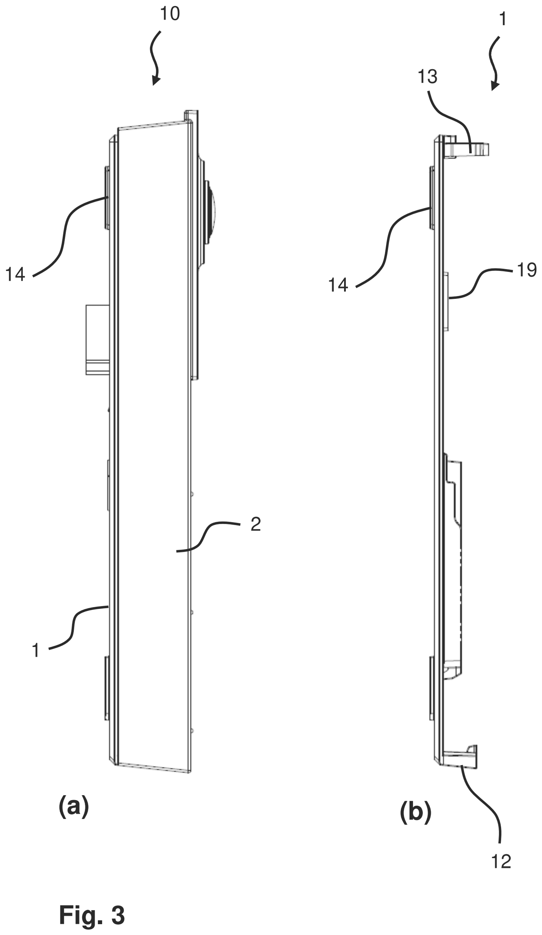

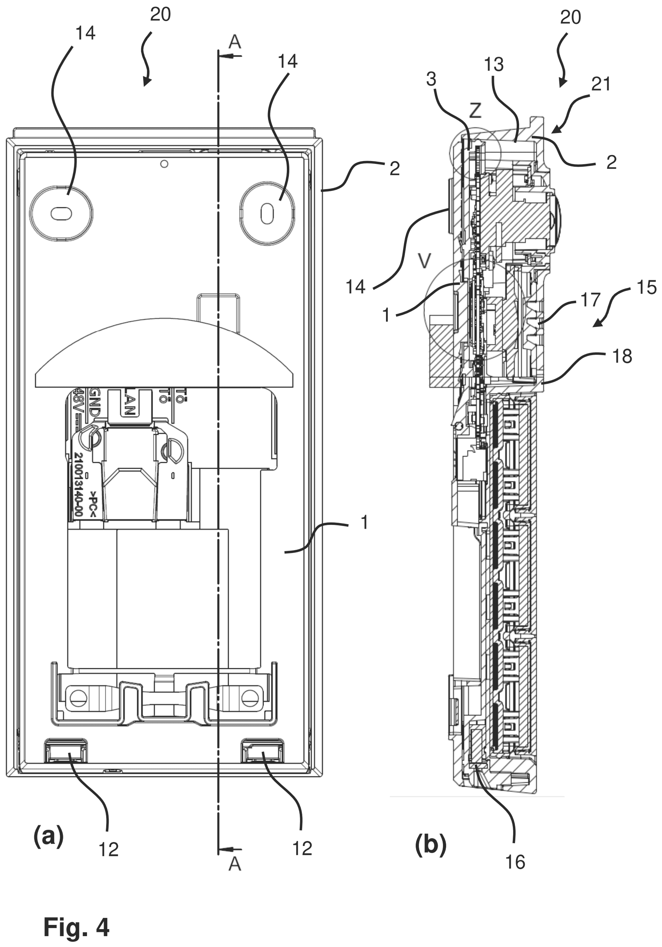

Fig. 3(a) zeigt ein zweites Gehäuseelement 2 angeordnet an einem ersten Gehäuseelement 1 in einer möglichen Ausführungsform. Fig. 3(b) zeigt ein erstes Gehäuseelement 1 in einer möglichen Ausführungsform. Das erste Gehäuseelement 1 kann zumindest eine Befestigungsschnittstelle 14 aufweisen, über welche das Gehäuse 10 an einer Gebäudewand oder Tür befestigt werden kann. Die Befestigungsschnittstelle 14 kann beispielsweise als Langloch ausgeführt sein, wie in Figur 4 dargestellt. So können zwei zueinander unterschiedlich ausgerichtete Langlöcher vorgesehen sein, um eine horizontale sowie vertikale Ausrichtung des Gehäuses 10 bei der Montage zu ermöglichen. Eine weitere Fixierung 21, die insbesondere ein Schraubenmittel, wie beispielsweise eine Inbusschraube mit oder ohne innenliegendem Pin aufweist, kann zur endgültigen Fixierung des zweiten Gehäuseelements 2 an dem ersten Gehäuseelement 1 dienen.

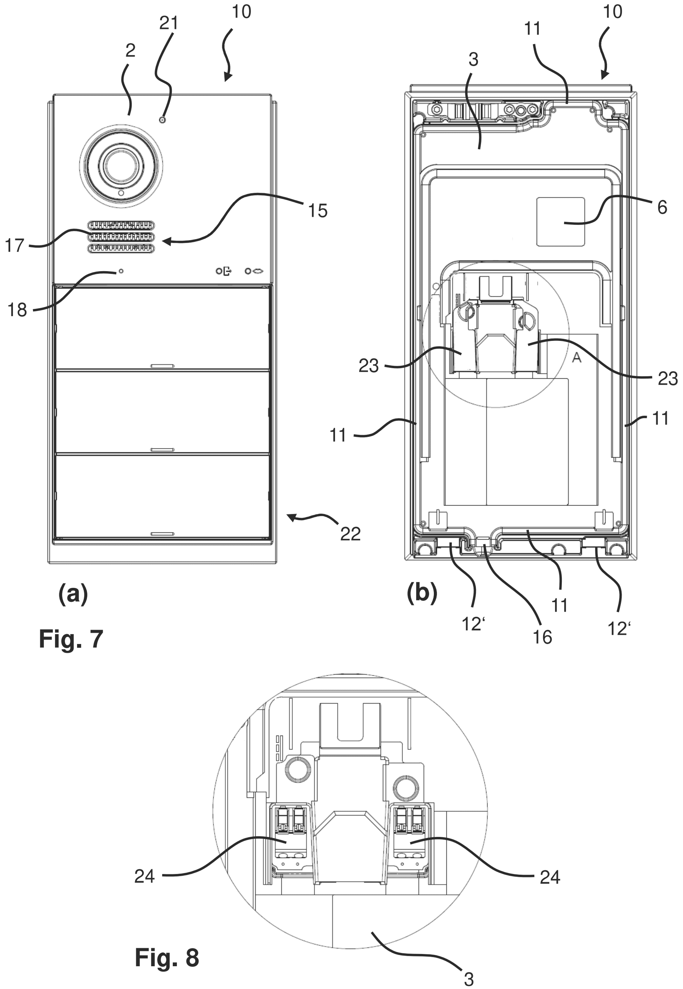

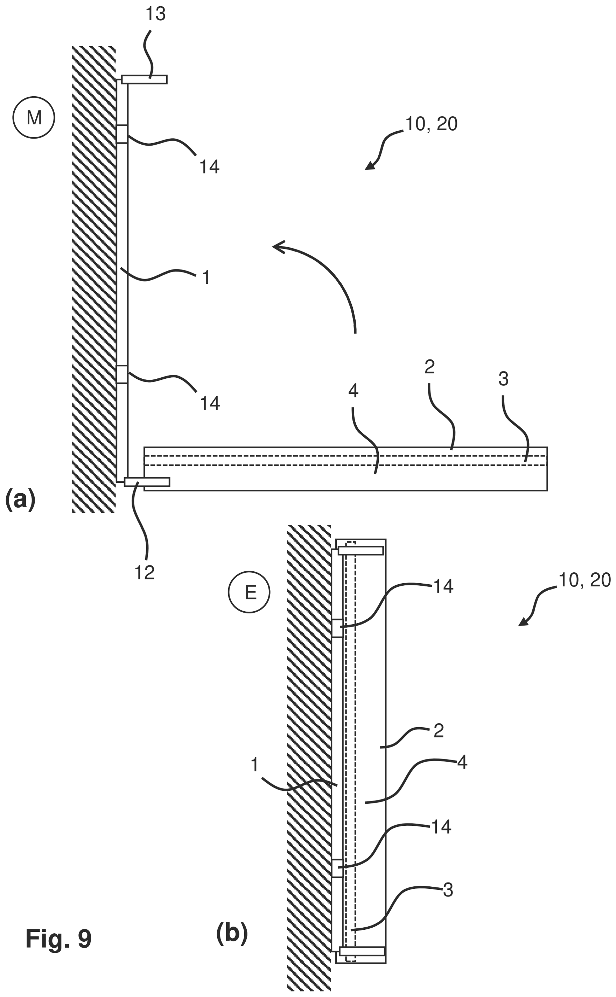

Wie in Fig. 3(b) dargestellt kann das erste Gehäuseelement 1 weiterhin eine Haltevorrichtung 12 sowie eine Rastvorrichtung 13 aufweisen. Die beiden Vorrichtungen 12, 13 sind beispielhaft an gegenüberliegenden Seiten des ersten Gehäuseelements 1 angeordnet. Das zweite Gehäuseelement 2 kann eine dazu korrespondierende Einhängevorrichtung 12', wie beispielhaft in Fig. 7(b) gezeigt, sowie eine dazu korrespondierende Rastvorrichtung aufweisen. Durch die Rastvorrichtung 12 und die Einhängevorrichtung 12' kann bevorzugt eine Montage wie in Figur 9 gezeigt ermöglicht werden.

Fig. 4 zeigt eine mögliche Ausführungsform eines Hauskommunikationsendgeräts 20 in einer Rückansicht, Fig. 4(a), und einer Schnittdarstellung, Fig. 4(b).

In Fig. 4 ist eine Lautsprechereinheit 15 sowie eine Mikrofoneinheit 16 dargestellt. Diese sind beabstandet zueinander an dem Gehäuse 10 vorgesehen, sodass Rückkopplungen vermieden werden können. Die Lautsprechereinheit 15 kann ein Lautsprecherelement 17 sowie ein Feuchteaustrittsloch 18 aufweisen. Das Feuchteaustrittsloch 18 ist unterhalb des Lautsprecherelements 17 angeordnet, sodass die Feuchtigkeit von dem Lautsprecherelement 17 zu dem Feuchteaustrittsloch 18 geführt werden kann. Wie in Fig. 7(a) gezeigt, kann die Lautsprechereinheit 17 zumindest einen Schlitz, insbesondere parallel zueinander angeordnete Schlitze, aufweisen, die in dem Gehäuse 10, insbesondere in dem zweiten Gehäuseelement 2, ausgebildet sind. Die Schlitze können relativ breit ausgebildet sein, wobei hinter den Schlitzen die Lautsprechereinheit platziert sein kann. Die Schlitze können mit einem Gitterelement, insbesondere einem Kunststoffgitter als Feuchtigkeitssperre, überspannt sein. Das Gitterelement kann demnach zwischen der Lautsprechereinheit 15 und dem zweiten Gehäuseelement 2 angeordnet sein. Dadurch kann verhindert werden, dass Regenwasser direkt an eine Membran des Lautsprecherelements 17 gelangt. Etwaige Regenflüssigkeit kann über das Feuchteaustrittsloch 18 abgeführt werden. Beispielsweise kann auch eine Bewegung der Membran ein Herauslaufen des eingetretenen Regenwassers unterstützen. Bevorzugt ist die Lautsprechereinheit 15 sowie die Mikrofoneinheit 16 gegen das zweite Gehäuseelement 2 abgedichtet. Die Mikrofoneinheit 16 ist bevorzugt in einem Bereich des Trennelements 3 bzw. an dem Trennelement 3 vorgesehen, Fig. 7(b). Dadurch kann die Mikrofoneinheit vor Feuchtigkeit geschützt werden.

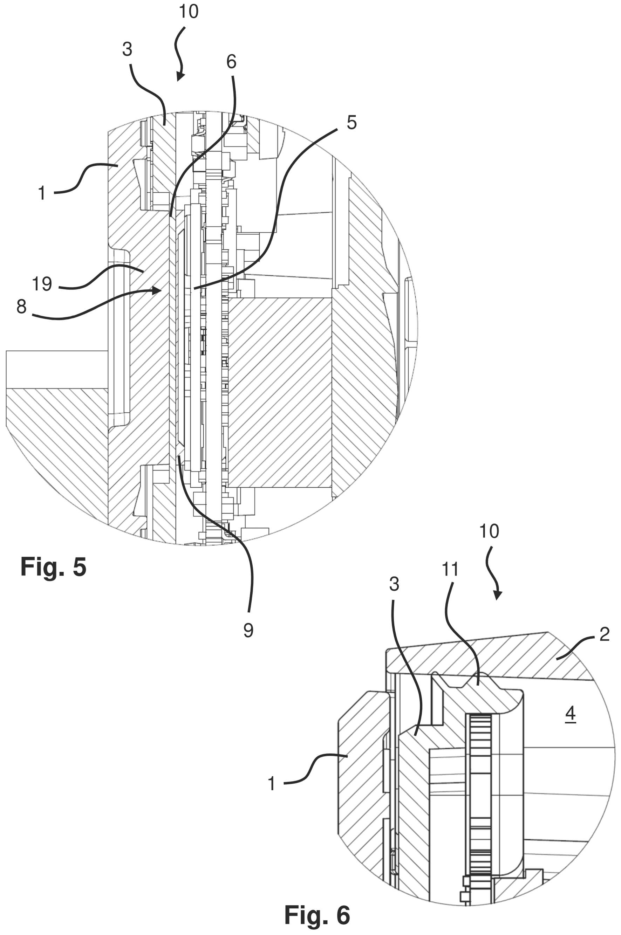

Fig. 5 zeigt eine Detailansicht aus Fig. 4, wobei der Teilbereich 6 des Trennelements 3 gezeigt ist. Dabei ist das Trennelement 3 mit der Materialdünnung im Teilbereich 6 gezeigt, und weiterhin das erste Gehäuseelement 1 mit einer Materialdickung im Teilbereich 19.

Fig. 6 zeigt eine weitere Detailansicht aus Fig. 4, wobei ein Randbereich des Gehäuses 10 gezeigt ist, in welchem das Dichtelement 11 angeordnet ist. Das Dichtelement 11 kann beispielsweise einteilig mit dem Trennelement 3 ausgeformt sein. Des Weiteren kann zumindest ein separates Dichtelement verwendet werden. Das Dichtelement 11 kann als einfache Dichtung, oder als Doppeldichtung ausgeführt sein. Insbesondere ist das Dichtelement 11 umlaufend um das Trennelement 3 ausgeformt, wie in Fig. 7(b) gezeigt.

Fig. 7 zeigt eine weitere mögliche Ausführungsform eines Hauskommunikationsendgeräts, in einer Vorderansicht, Fig. 7(a), und einer Rückansicht, Fig. 7(b). In der Rückansicht ist das erste Gehäuseelement 1 nicht dargestellt. Ein Teil des Gehäuses 10, insbesondere des zweiten Gehäuseelements 2, kann durch ein Tastenfeld 22 ausgeformt sein, welches lediglich beispielhaft dargestellt ist.

Fig. 8 zeigt eine Detailansicht aus Fig. 7. Das Trennelement 3 kann wie dargestellt zumindest eine Öffnung aufweisen, welche durch zumindest eine Abdeckung 23 verschlossen werden kann. Anschlussklemmen 24, die unter der zumindest eine Abdeckung 23 angeordnet sein können, können dadurch temporär erreicht werden. Dies kann insbesondere für die Montage, wie in Fig. 9 gezeigt, von Vorteil sein. Die Abdeckung 23 kann gegenüber dem Trennelement 3 abgedichtet ausgeführt sein.

Fig. 9 zeigt eine schematische Darstellung eines Hauskommunikationsendgeräts 20 während und nach der Montage. Über die Haltevorrichtung 12 kann das zweite Gehäuseelement 2 in einer Montageposition M an dem ersten Gehäuseelement 1 eingehängt bzw. arretiert werden, Fig. 9(a). In einer derartigen Montageposition M ist das erste Gehäuseelement 1 bereits an einer Gebäudewand oder Tür, bevorzugt über die zumindest eine Befestigungsschnittstelle 14, vormontiert angeordnet. Das zweite Gehäuseelement 2 ist beispielsweise wie dargestellt quer zu dem ersten Gehäuseelement 1 ausgerichtet, insbesondere im Wesentlichen in einem rechten Winkel dazu ausgerichtet. Dies hat den Vorteil, dass das zweite Gehäuseelement 2 während der Montage nicht gehalten werden muss und das Trennelement 3 von einer Montageperson erreicht werden kann, um die elektronischen Komponenten zu kontaktieren.

Weiterhin kann das erste Gehäuseelement 1 bereits vormontiert werden, wobei kostenrelevante Bauteile erst mit dem zweite Gehäuseelement 2 montiert werden.

Wie in Figur 9 (b) gezeigt, kann das zweite Gehäuseelement 2 zum Erreichen einer Endposition E verschwenkt werden, um für die Endposition E parallel zu dem ersten Gehäuseelement 1 ausgerichtet zu werden. In der Endposition E kann das zweite Gehäuseelement 2 an der Rastvorrichtung 13 des ersten Gehäuseelements 1 einrasten.

Mit den gezeigten Ausführungsformen kann insbesondere ein Abführen von im Inneren des Gehäuses 10 entstehender Wärme erreicht werden. Zu diesem Zweck kann das Gehäuse 10 aus einem Druckguss-Material ausgeformt sein, und mit den wärmeemittierenden Komponenten gekoppelt sein. Beispielsweise kann das Druckgussmaterial oberflächenbehandelt sein. Das Trennelement 3 trennt insbesondere den Bereich der Leiterplatte mit der Stromversorgung von einem Bereich des von außen zugänglichen Bedienfelds. In einer weiteren Ausführungsform kann die Dichtung 11 den Bereich der Leiterplatte sowie einen Bereich einer Kameraeinheit und/oder einer Mikrofoneinheit 16 nach außen abdichten.

Durch die Haltevorrichtung 12 kann weiterhin eine Art Montagehilfe bereitgestellt werden, mit welcher das zweiten Gehäuseelement 2 zunächst an dem ersten Gehäuseelement 1 eingehängt werden kann, bevor eine endgültige Montage erfolgt. Dies erleichtert insbesondere die Montage des ersten Gehäuseelements und kann weiterhin eine Vormontage des ersten Gehäuseelements 1 an einer Gebäudewand oder Tür ermöglichen.

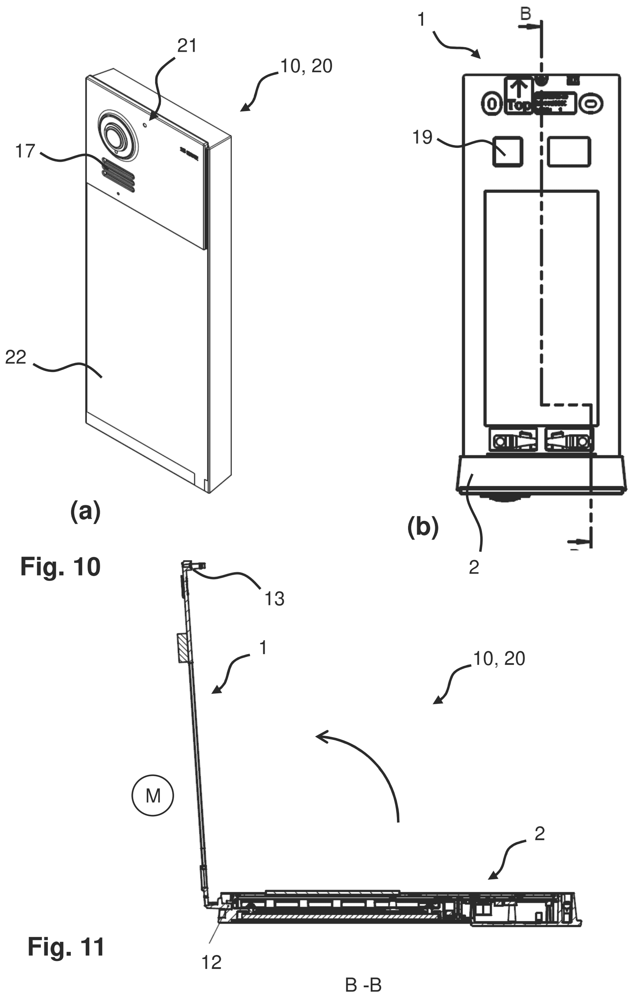

Fig. 10 (a) zeigt ein Gehäuse 10 in einer weiteren möglichen Ausführungsform. Das Tastenfeld 22 kann wie dargestellt auch einteilig ausgebildet sein. Fig. 10 (b) zeigt eine Montageposition, die in Fig. 11 in einer Schnittdarstellung entlang der Linie B-B dargestellt ist. In der Ansicht nach Fig. 10 (b) ist das erste Gehäuseelement 1 erkennbar, wie es an einer Gebäudewand oder Tür montiert sein kann. Im unteren Bereich ist das zweite Gehäuseelement 2 erkennbar, das eingehängt an dem ersten Gehäuseelement 1 dargestellt ist, wie in Fig. 11 gezeigt. Das erste und zweite Gehäuseelement 1, 2 können in der Montageposition M in Wesentlichen quer zueinander ausgerichtet sein. Beispielsweise können die Gehäuseelemente 1, 2 in einem Winkel von 80° bis 110° zueinander ausgerichtet sein. Fig. 11 zeigt eine mögliche Ausführung, in welcher die Gehäuseelemente 1, 2 in einem Winkel etwas größer als 90° zueinander ausgerichtet sind, wenn das zweite Gehäuseelement 2 über die Einhängevorrichtung 12' an der Haltevorrichtung 12 des ersten Gehäuseelements 1 gehalten ist.

Die Haltevorrichtung 12 und die Einhängevorrichtung 12' können eine gemeinsame Drehachse ausbilden, um welche das zweite Gehäuseelement 2 rotiert werden kann, um in die Endposition E zu gelangen.

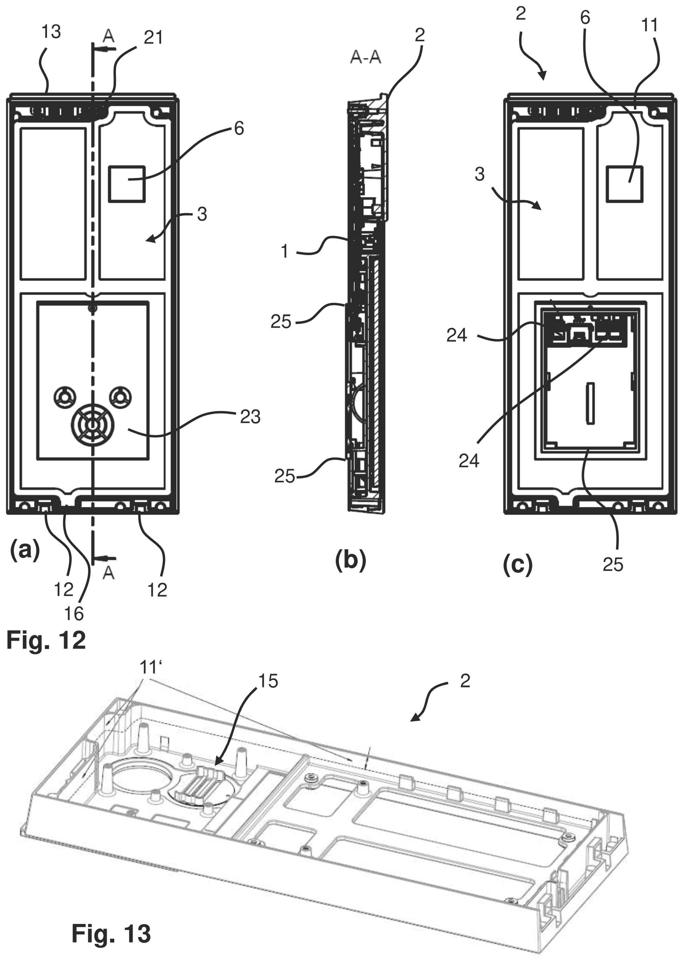

Fig. 12 zeigt ein Gehäuse 10 in weiteren möglichen Ausführungsformen. Fig. 12 (a) zeigt eine Ansicht, in welcher das Trennelement 3 an dem zweiten Gehäuseelement 2 angeordnet ist. Fig. 12 (b) zeigt eine Schnittdarstellung entlang der Linie A-A und Fig. 12 (c) eine Ansicht ohne Abdeckung 23, sodass die Anschlussklemmen 24 erkennbar sind.

Die Abdeckung 23 kann über eine Dichtung 25, die insbesondere als um die Abdeckung 23 umlaufende Dichtung ausgebildet ist, gegenüber dem Trennelement 3 abgedichtet sein.

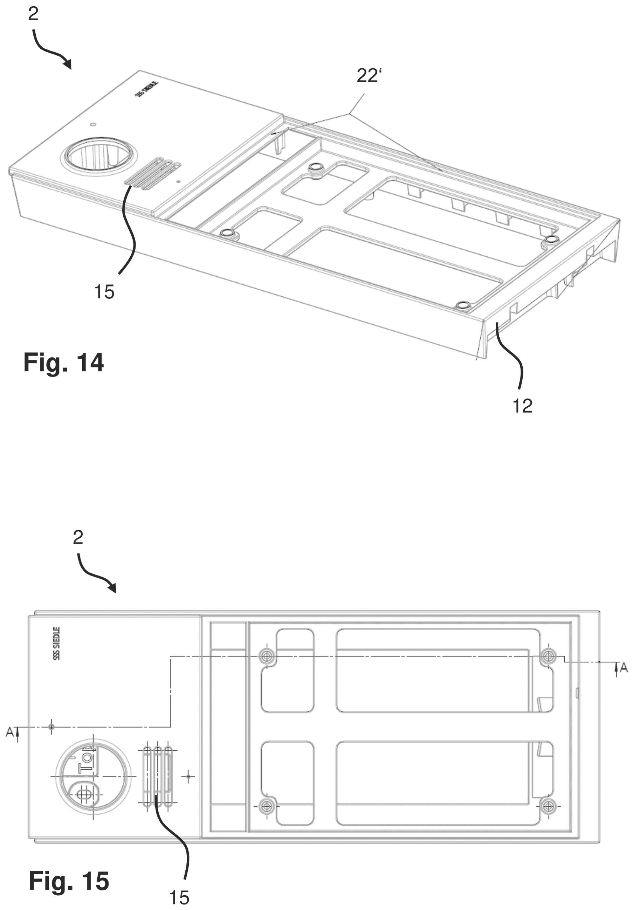

Fig. 13 zeigt ein zweites Gehäuseelement 2 in einer weiteren möglichen Ausführungsform. Das zweite Gehäuseelement 2 kann eine umlaufende Dichtfläche 11' aufweisen, an welcher die umlaufende Dichtung 11 mit dem Trennelement 3 ausgebildet werden kann. Die umlaufende Dichtfläche 11' kann eine Innenoberfläche des zweiten Gehäuseelements 2 ausbilden. Die Figuren 14 und 15 zeigen weitere Ansichten der Ausführungsform aus Fig. 13. Das Gehäuseelement 2 kann beispielsweise eine Aufnahme 22' für das Tastenfeld aufweisen.

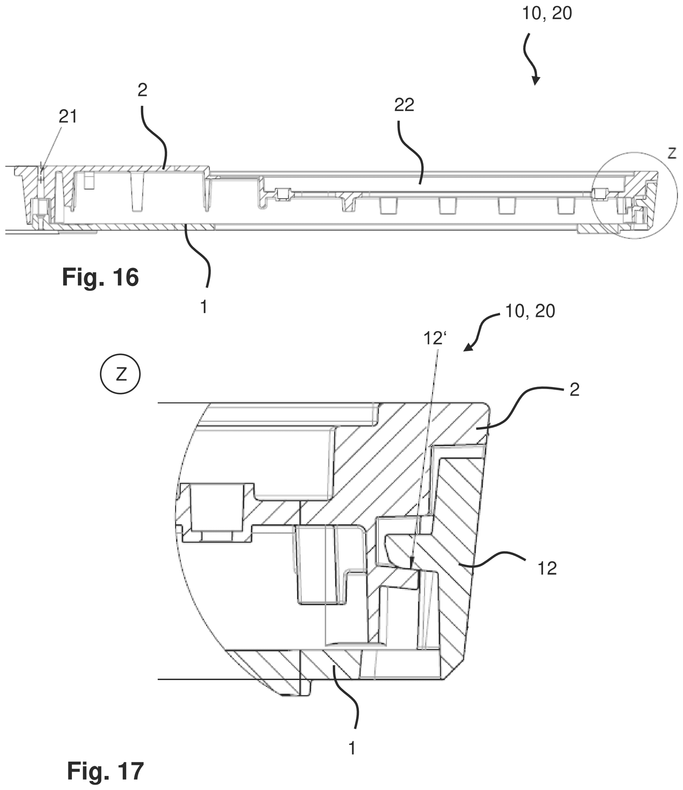

Fig. 16 zeigt eine weitere Ansicht der Ausführungsform aus Fig. 13, wobei das zweite Gehäuseelement 2 angeordnet an dem ersten Gehäuseelement 1 dargestellt ist. Die Darstellung zeigt die beiden Gehäuseelemente 1, 2 ohne Trennelement 3. Eine Öffnung, insbesondere eine Durchgangsbohrung, der Fixierung 21, in welcher eine Inbusschraube angeordnet werden kann, durchgreift hierbei das zweite Gehäuseelement 2. In dem ersten Gehäuseelement 1 kann ebenso eine entsprechende Öffnung, als Durchgangs- oder Sackloch, vorgesehen sein.

Fig. 17 zeigt eine Detailansicht aus Fig. 16. Dabei ist erkennbar, wie die beiden Gehäuseelemente über die Haltevorrichtung 12 ineinander eingreifen bzw. einhaken können.

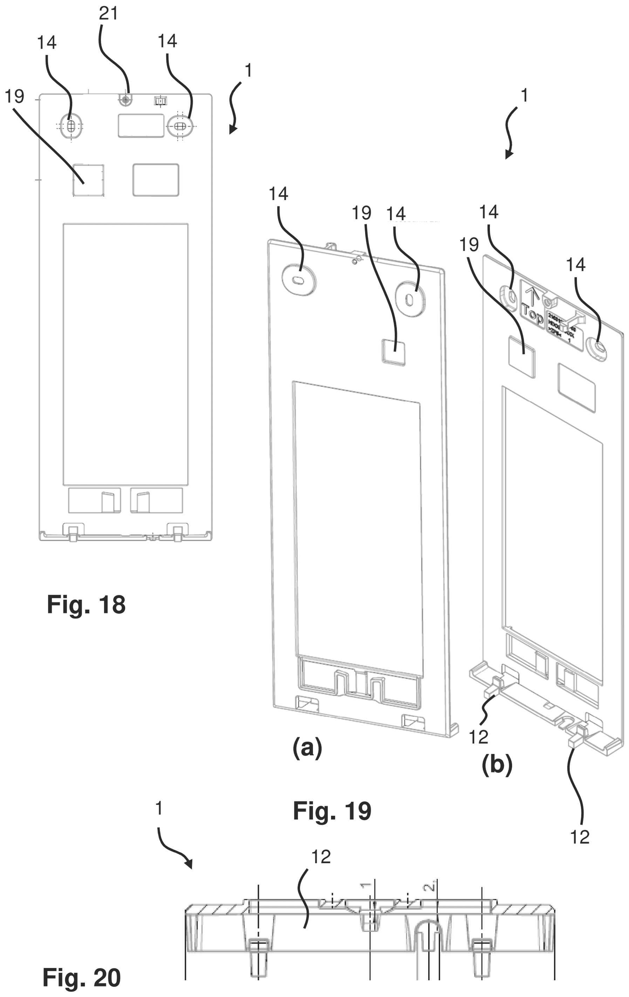

Die Figuren 18 und 19 zeigen ein erstes Gehäuseelement 1 in einer weiteren möglichen Ausführungsform. Dabei ist eine weitere Ausführung eines korrespondierenden Teilbereichs 19 dargestellt. Fig. 20 zeigt eine Schnittdarstellung aus Fig. 19, wobei die Ansicht in Richtung Haltevorrichtung 12 ausgerichtet ist.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

### Bezugszeichenliste

- 1: erstes Gehäuseelement
- 2: zweites Gehäuseelement
- 3: Trennelement
- 4: Gehäuseinnenraum
- 5: elektronische Komponente
- 6: Teilbereich des Trennelements
- 7: weiterer Bereich
- 8: Vertiefung
- 9: wärmeleitende Schicht
- 10: Gehäuse
- 11: Dichtelement
- 12: Haltevorrichtung
- 13: Rastvorrichtung
- 14: Befestigungsschnittstelle
- 15: Lautsprechereinheit
- 16: Mikrofoneinheit
- 17: Lautsprecherelement
- 18: Feuchteaustrittsloch
- 19: korrespondierender Teilbereich
- 20: Hauskommunikationsendgerät
- 21: Fixierung
- 22: Tastenfeld
- 23: Abdeckung
- 24: Anschlussklemme

- M: Montageposition
- E: Endposition

## Patentansprüche

1. Gehäuse (10) für oder in einem Hauskommunikationsendgerät einer Hauskommunikationsanlage, insbesondere für ein als Türstation ausgebildetes Hauskommunikationsendgerät,
mit einem ersten Gehäuseelement (1), das zur Montage an einer Gebäudewand oder Tür ausgebildet ist,
mit einem zweiten Gehäuseelement (2), das zur Montage an dem ersten Gehäuseelement (1) ausgebildet ist, und
mit einem zwischen dem ersten Gehäuseelement (1) und dem zweiten Gehäuseelement (2) angeordneten Trennelement (3), das dazu ausgebildet ist, mit dem zweiten Gehäuseelement (2) einen Gehäuseinnenraum (4) zu definieren,
wobei das Trennelement (3) dazu ausgebildet ist, Wärme von zumindest einer elektronischen Komponente (5), die in dem Gehäuseinnenraum (4) angeordnet ist, zu dem ersten Gehäuseelement (1) zu leiten.

2. Gehäuse nach Anspruch 1,
**dadurch gekennzeichnet,**
**dass** das Trennelement (3) zumindest einen Teilbereich (6) aufweist, der eine geringere Querschnittsfläche als zumindest ein weiterer Bereich (7) des Trennelements (3) aufweist.

3. Gehäuse nach Anspruch 2,
**dadurch gekennzeichnet,**
**dass** der Teilbereich (6) eine geringere Querschnittsfläche als daran angrenzende Bereiche des Trennelements aufweist und/oder eine einseitige Vertiefung (8) in dem Trennelement (3) ausbildet.

4. Gehäuse nach Anspruch 2 oder 3,
**dadurch gekennzeichnet,**
**dass** der Teilbereich (6) an eine Größe und/oder Form der zumindest einen elektronischen Komponente (5) angepasst ist.

5. Gehäuse nach einem der vorstehenden Ansprüche,
**dadurch gekennzeichnet,**
**dass** das Trennelement (3) zumindest ein Kunststoffmaterial umfasst oder aus einem Kunststoffmaterial ausgebildet ist.

6. Gehäuse nach einem der vorstehenden Ansprüche,
**dadurch gekennzeichnet,**
**dass** das erste Gehäuseelement (1) und/oder das zweite Gehäuseelement (2) aus einem Gussmaterial ausgebildet ist.

7. Gehäuse nach einem der vorstehenden Ansprüche,
**dadurch gekennzeichnet,**
**dass** die elektronische Komponente (5) zumindest einen Mikrocontroller oder Mikroprozessor aufweist, der bevorzugt direkt oder mittels einer wärmeleitenden Schicht (9) mit dem Trennelement kontaktierbar ist.

8. Gehäuse nach einem der vorstehenden Ansprüche,
**dadurch gekennzeichnet,**
**dass** das Trennelement (3) zur Abdichtung des Gehäuseinnenraums ein umlaufendes Dichtelement (11) aufweist.

9. Gehäuse nach einem der vorstehenden Ansprüche,
**dadurch gekennzeichnet,**
**dass** das erste Gehäuseelement (1) eine Haltevorrichtung (12) aufweist, an welcher das zweite Gehäuseelement (2) während der Montage in einer Montageposition (M) an dem ersten Gehäuseelement (1) ausrichtbar und haltbar ist, wobei bevorzugt das Trennelement (3) in der Montageposition (M) erreichbar ist.

10. Gehäuse nach Anspruch 9,
**dadurch gekennzeichnet,**
**dass** das erste Gehäuseelement (1) eine Rastvorrichtung (13) aufweist, an welcher das zweite Gehäuseelement (1) zur Montage in einer Endposition (E) an dem ersten Gehäuseelement (1) rastbar ist, wobei das zweite Gehäuseelement (2) in der Endposition (E) an der Haltevorrichtung (12) und an der Rastvorrichtung (13) ausrichtbar und/oder arretierbar ist.

11. Gehäuse nach einem der vorstehenden Ansprüche,
**dadurch gekennzeichnet,**
**dass** das erste Gehäuseelement (1) zumindest eine Befestigungsschnittstelle (14) aufweist, über welche das Gehäuse (10) an der Gebäudewand oder Tür befestigbar ist.

12. Gehäuse nach einem der vorstehenden Ansprüche,
**dadurch gekennzeichnet,**
**dass** das zweite Gehäuseelement (2) eine Lautsprechereinheit (15) und eine Mikrofoneinheit (16) aufweist, die beabstandet zueinander an dem zweiten Gehäuseelement (2) angeordnet sind, wobei diese bevorzugt gegenüber dem zweiten Gehäuseelement (2) abgedichtet sind.

13. Gehäuse nach Anspruch 12,
**dadurch gekennzeichnet,**
**dass** die Lautsprechereinheit (15) zumindest ein Lautsprecherelement (17) und unterhalb des Lautsprecherelements (17) zumindest ein Feuchteaustrittsloch (18) aufweist, wobei Feuchtigkeit von dem Lautsprecherelement (17) zu dem Feuchteaustrittsloch (18) führbar und durch das Feuchteaustrittsloch (18) aus dem zweiten Gehäuseelement (2) nach außerhalb des Gehäuses (10) leitbar ist.

14. Hauskommunikationsendgerät (20), das eine Innenstation und/oder Türstation einer Hauskommunikationsanlage ausbildet, aufweisend ein Gehäuse (10) nach einem der vorherigen Ansprüche.

15. Hauskommunikationsanlage,
mit mindestens einer Innenstation und mit mindestens einer Türstation, wobei zumindest eine Innenstation und/oder Türstation als Hauskommunikationsendgerät (20) nach Anspruch 14 mit einem Gehäuse (10) nach einem der Ansprüche 1 bis 13 ausgebildet ist.
